# EUROPEAN PATENT SPECIFICATION

(11) **EP 0 404 464 B1**
(45) Date of publication and mention of the grant of the patent: **13.03.1996**
(21) Application number: 90306591.0
(22) Date of filing: 18.06.1990
(51) Int. Cl.: H01L 21/331, H01L 21/82

(54) **Manufacture of semiconductor devices**
Herstellen von Halbleitervorrichtungen
Fabrication de dispositifs semi-conducteurs

(30) Priority: 19.06.1989 JP 156434/89
(43) Date of publication of application: 27.12.1990
(73) Proprietor: SONY CORPORATION, Tokyo 141 (JP)
(72) Inventor: Hozumi, Hiroki, Shinagawa-ku Tokyo (JP)
(74) Representative: Cotter, Ivan John

(56) References cited:
- EP-A- 0 007 923
- EP-A- 0 183 204
- EP-A- 0 227 970
- US-A- 4 471 525

## Description

This invention relates to the manufacture of semiconductor devices.

In previously known bipolar transistor manufacturing methods, it has generally been customary to adopt procedures which comprise the steps of first forming a buried layer and an N-type epitaxial layer, and then double-diffusing impurities of first and second conduction types selectively into an active region which is surrounded by isolated inter-element regions, thereby forming a base region and an emitter region.

The latest developments of process technology have given rise to requirements for realising higher integration densities and higher operational speeds of the elements. For the purpose of meeting such requirements, it is usual to employ a polycrystalline silicon washed emitter (hereinafter referred to simply as a poly-washed emitter) structure. The use of a poly-washed emitter structure makes it possible to form a self-matched emitter region. Such structure contributes to a reduction in size of an emitter opening (which results in reduction of the cell size), and also to a decrease of base broadening resistance Rbb′ which consequently results in advantages which allow obtaining a higher integration density and higher operational speeds of the elements.

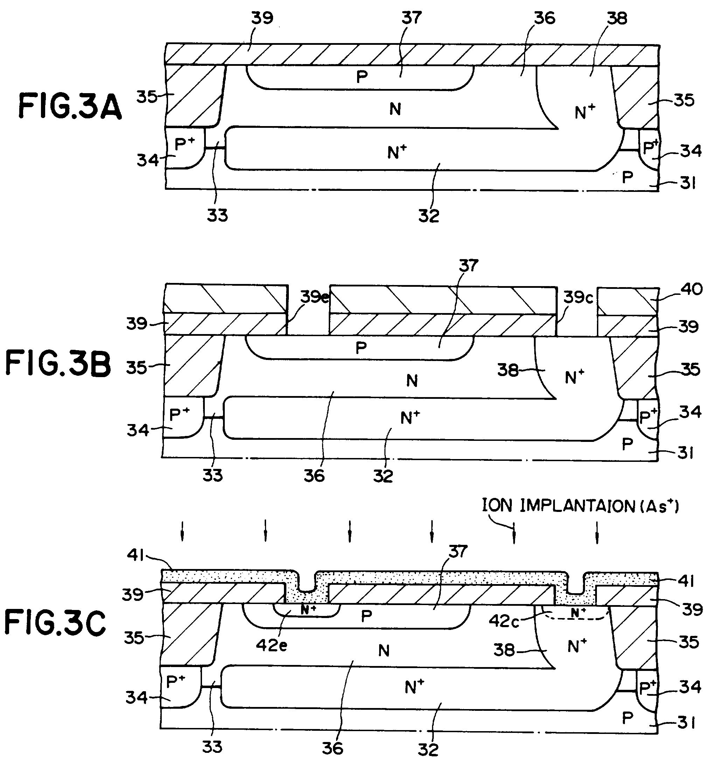

A description of a previously proposed method for the manufacture of a bipolar transistor which has a poly-washed emitter structure will now be given with reference to Figures 3A to 3F of the accompanying drawings. First, as shown in Figure 3A, an N-type buried layer 32 and an N-type epitaxial layer 33 are formed on a P-type semiconductor substrate 31. Then, a P-type isolated inter-element region 34 and another isolated inter-element region 35 composed of a thick thermal oxide layer are formed. Then, a P-type impurity is selectively ion-implanted into an active region 36 which is surrounded by the isolated inter-element regions 34 and 35 to thereby form a base region 37. An N-type impurity is ion-implanted into a portion where a collector contact is to be formed, thereby forming a collector lead region 38 which extends to the buried layer 32. Subsequently, a silicon dioxide film 39 is formed by chemical vapour deposition (CVD) or the like on the entire surface inclusive of the active region 36.

Thereafter, as shown in Figure 3B, the silicon dioxide film 39 is selectively etched through a resist mask 40 so as to form open windows 39e and 39c in the portions corresponding to the emitter region (which will serve also as an emitter contact) and the collector contact of the active region 36.

In the next step, as shown in Figure 3C, the resist mask 40 on the silicon dioxide film 39 is removed, and a polycrystalline silicon layer 41 is formed on the silicon dioxide film 39 including the windows 39e and 39c. Thereafter, an N-type impurity (e.g. As⁺) is ion-implanted into the polycrystalline silicon layer 41, and a heat treatment is performed so as to diffuse the N-type impurity from the polycrystalline silicon layer 41, thereby forming an emitter region 42e (which serves also as an emitter contact) and a collector contact 42c (which is represented by a broken line) in a self-matched state.

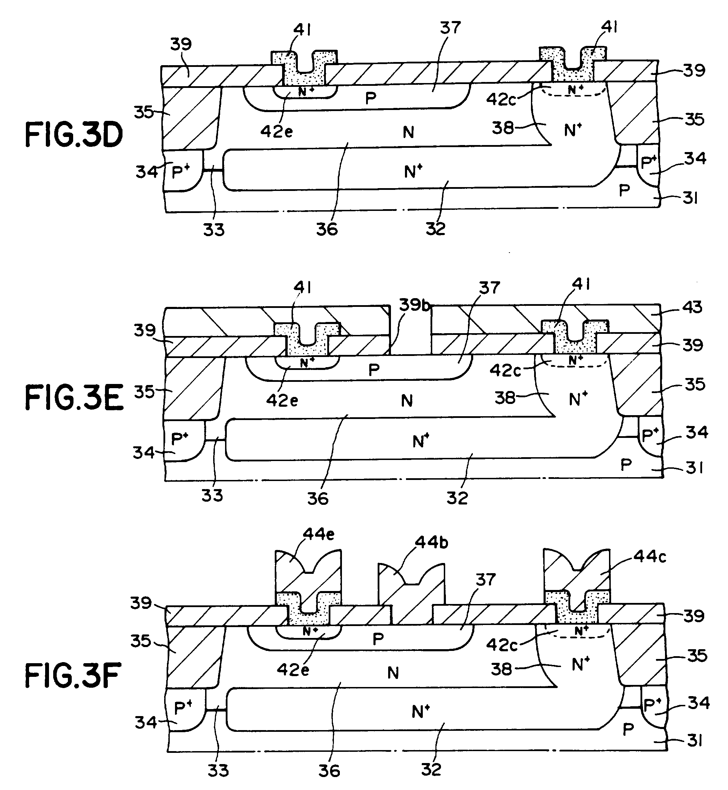

Subsequently, as shown in Figure 3D, the polycrystalline silicon layer 41 is patterned.

In the next step, as shown in Figure 3E, a resist mask 43 is formed on the polycrystalline silicon layer 41 and the silicon dioxide film 39, and then the silicon dioxide film 39 is etched through the resist mask 43 so as to form a window 39b at a position which corresponds to the base contact.

Subsequently, as shown in Figure 3F, an aluminium layer is formed on the entire surface after removal of the resist film 43, and the aluminium layer is patterned so as to form an emitter electrode 44e which is connected to the emitter region 42e through the polycrystalline silicon layer 41, a base electrode 44b which is connected to the base region 37, and a collector electrode 44c which is connected to the collector contact 42c through the polycrystalline silicon layer 41. A desired bipolar transistor is thus produced.

According to the above-described previously proposed method of manufacturing a bipolar transistor, the step of forming the windows 39e and 39c which are opposed to the emitter region 42e and the collector contact 42c is different from the step of forming the window 39b which is opposed to the base region 37, whereby a total of two resist masks (the above-mentioned masks 40 and 43) are required for opening the windows. Particularly when forming a composite device comprising a transistor, a resistor, a capacitor and so forth, a window opening resist mask is required for forming each element, which makes the window opening step complicated. Also, for ion-implantation, resist masks generally are required to be in conformity with the individual conduction types of the impurities, so that a multiplicity of resist masks are required for forming elements and these are additional to the aforementioned window opening resist masks, whereby the manufacture of a composite device becomes complicated.

It has recently been observed that, in accordance with a trend towards faster operation and higher frequency band in the linear technical field for public use (including analog integrated circuits (ICs), analog large scale integration (LSI) devices, etc.), some devices have been proposed which utilise the poly-washed emitter type in the general linear process as well. For the purpose of improving the noise and frequency characteristics, it is desired that a metal-insulator-semiconductor (MIS) capacitor be employed as a filter. However, since a composite device is produced by a combination of different steps for the individual elements as described above, the steps become complicated and adverse influences occur due to heat treatment and so forth when forming other elements, which consequently causes a deterioration in the precision of control of the capacitance, thereby causing additional difficulties during manufacture (including the simultaneous production of an MIS capacitor for a transistor of a poly-washed emitter structure).

According to a first aspect of the invention there is provided a method of manufacturing a transistor and a resistor, the method being set out in claim 1 hereof.

According to a second aspect of the invention there is provided a method of manufacturing a transistor, a resistor and a capacitor, the method being set out in claim 2 hereof.

Preferred embodiments of the invention described hereinbelow solve or at least alleviate the problems described above; and provide semiconductor device manufacturing methods which are capable of enabling simultaneous production of a transistor and at least one other element (at least a resistor and, optionally, a transistor of another type, and/or a capacitor) in which the process steps during manufacture are simplified.

The invention will now be further described, by way of illustrative and non-limiting example, with reference to the accompanying drawings, in which:
Figures 1A to 1J illustrate sequential steps of a first method embodying the invention for manufacturing a composite semiconductor device;
Figures 2A to 2M illustrate sequential steps of a second method embodying the invention for manufacturing a composite device; and
Figures 3A to 3F illustrate sequential steps of a previously proposed method of manufacturing a bipolar transistor.

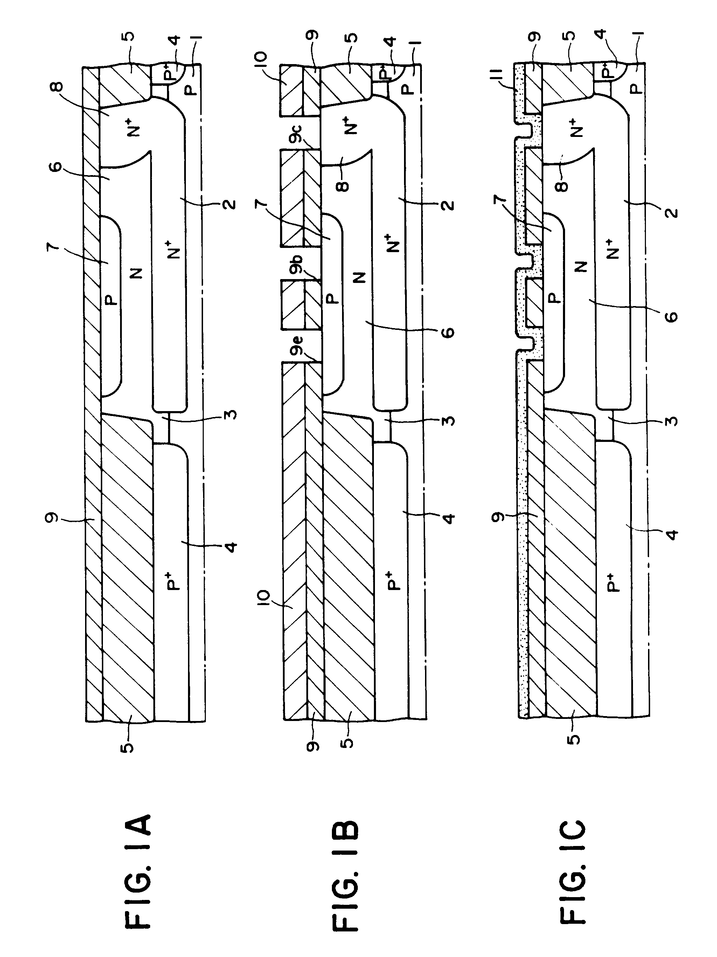

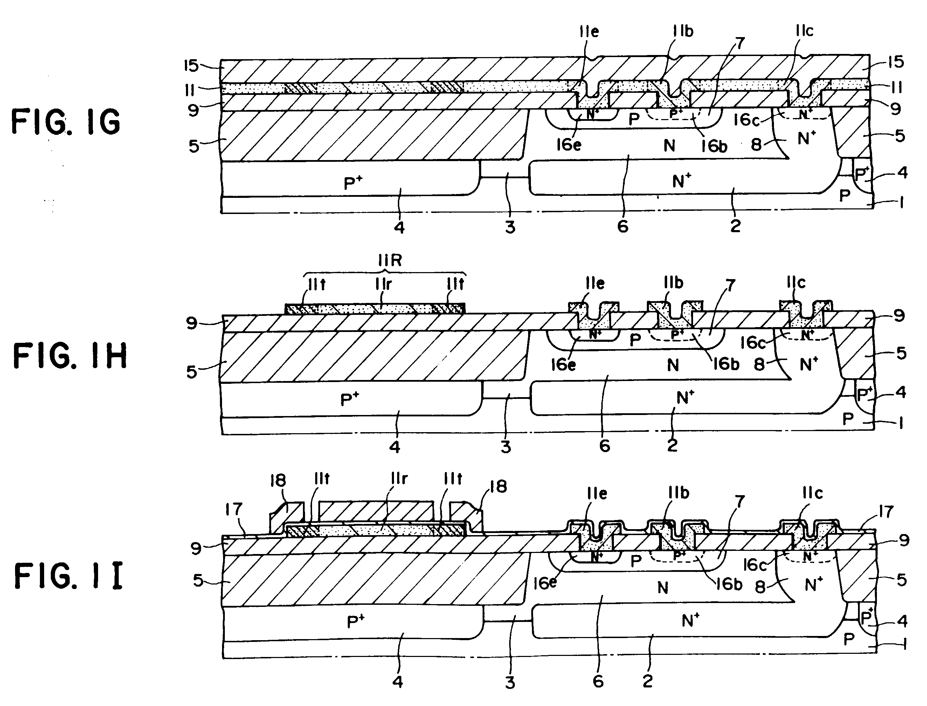

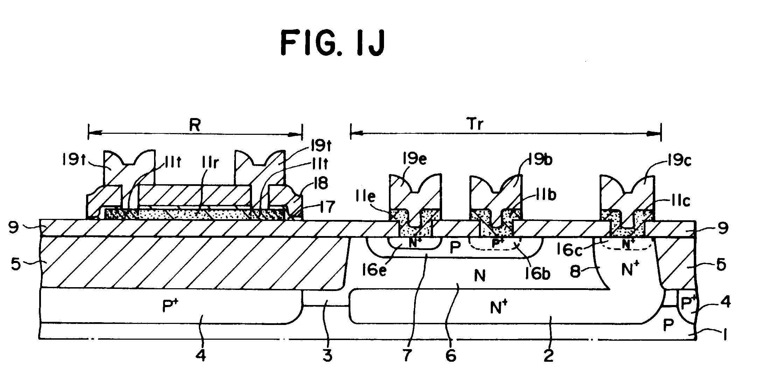

Figures 1A to 1J illustrate a first semiconductor device manufacturing method embodying the invention and, in particular, sequential steps in the method, which is for simultaneously producing an NPN type bipolar transistor of a poly-washed emitter structure and a resistor composed of polycrystalline silicon. The individual steps will be described sequentially.

First, as shown in Figure 1A, an N-type buried layer 2 and an N-type epitaxial layer 3 are formed on a P-type semiconductor substrate (e.g. a silicon substrate) 1, and then a P-type isolated inter-element region 4 and another isolated inter-element region 5 in the form of a thick thermal oxide layer (e.g. a silicon dioxide layer) are formed. Then, a P-type impurity is selectively ion-implanted into an active region 6 which is surrounded by the isolated inter-element regions 4 and 5, to thereby form a base region 7. Simultaneously, an N-type impurity is ion-implanted into a portion where a collector contact is to be formed, thereby forming an N-type collector lead region 8 which extends to the buried layer 2. Then, a silicon dioxide layer 9 is formed by chemical vapour deposition (CVD) or the like on the entire surface inclusive of the active region 6.

Subsequently, as shown in Figure 1B, a resist mask 10 is formed on the silicon dioxide film 9, and the film 9 is then selectively etched through the resist mask 10 to open, simultaneously (that is, in the same process (etching) step), windows 9e, 9b, 9c which correspond, respectively, to an emitter region (which serves also as an emitter contact), a base contact and the collector contact in the active region.

In the next step, as shown in Figure 1C, the resist mask 10 on the silicon dioxide film 9 is removed and a polycrystalline silicon layer 11 is formed by CVD or the like on the silicon dioxide film 9 including the windows 9e, 9b, 9c.

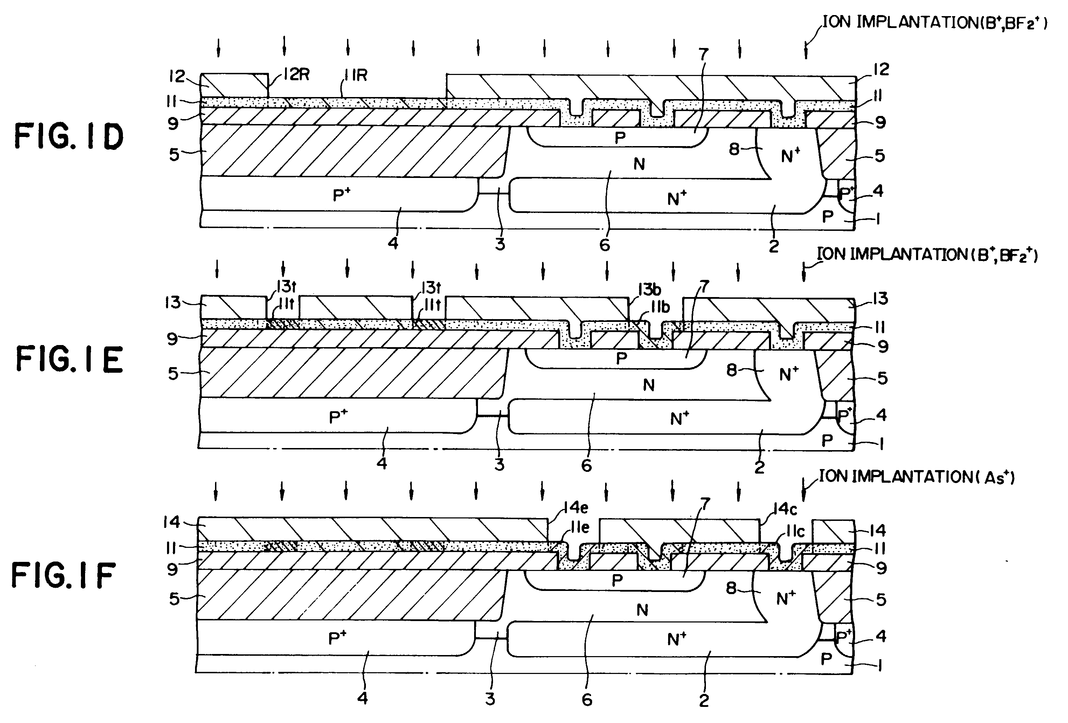

Subsequently, as shown in Figure 1D, a resist mask 12 is formed on the polycrystalline silicon layer 11, and a P-type impurity, such as a boron impurity (e.g. B⁺, BF₂ ⁺), is ion-implanted through a window 12R of the resist mask 12 into a portion 11R which serves as a resistor part 11r constituted by the polycrystalline silicon layer 11.

Then, as shown in Figure 1E, the resist mask 12 on the polycrystalline silicon layer 11 is removed and another resist mask 13 is formed on the layer 11. Thereafter, a P-type impurity (e.g. B⁺, BF₂ ⁺) is ion-implanted through windows 13t, 13b of the resist mask 13 into resistor contact portions 11t of the polycrystalline silicon layer 11 and a portion 11b which corresponds to the base contact and later partially constitutes a base electrode.

Next, as shown in Figure 1F, the resist mask 13 on the polycrystalline silicon layer 11 is removed and a resist mask 14 is formed on the layer 11. Thereafter, an N-type impurity (e.g. As⁺) is ion-implanted through windows 14e, 14c of the resist mask 14 into a portion 11e which corresponds to the emitter region of the polycrystalline silicon layer 11 and later partially constitutes an emitter electrode, and a portion 11c which corresponds to the collector contact of the layer 11 and later partially constitutes a collector electrode.

Subsequently, as shown in Figure 1G, the resist mask 14 on the polycrystalline silicon layer 11 is removed and then a silicon dioxide film 15 is formed on the layer 11 by CVD or the like. The silicon dioxide film 15 functions as a cap film for preventing scattering of the impurities from the polycrystalline silicon layer 11 during heat treatment, which is to be performed during the next step, and also for preventing the mutual mixing of impurities of different conduction types. Thereafter, the heat treatment is performed. In this stage, the N-type impurities from both the portion 11e of the polycrystalline silicon layer 11 which corresponds to the emitter region and the portion 11c of the layer 11 which corresponds to the collector contact are diffused into the base region 7 and the collector lead region 8, which are located under such portions respectively, thereby forming an emitter region l6e and a collector contact 16c (shown by a broken line). Simultaneously, the P-type impurity from the portion 11b which corresponds to the base contact of the polycrystalline silicon layer 11 is diffused into the base region 7 so as to form a base contact 16b (shown by a broken line).

In the next step, as shown in Figure 1H, the cap silicon dioxide film 15 on the polycrystalline silicon layer 11 is entirely removed, and then the layer 11 is patterned. In this stage, the patterning is performed so as to leave the resistor part 11r, the resistor contact portions 11t, the portion 11e which corresponds to the emitter region 16e, the portion 11b which corresponds to the base contact 16b, and the portion 11c which corresponds to the collector contact 16c.

Subsequently, as shown in Figure 1I, a relatively thin Si₃N₄ film 17 is formed on the entire surface by decompressed CVD or the like, and then a relatively thick silicon dioxide film 18 is formed on the entire surface. Thereafter, the silicon dioxide film 18 is patterned so as to be partially left on the resistor part 11r and the resistor contact portions 11t. In this state, the Si₃N₄ film 17 functions as an etching stopper to prevent removal of the silicon dioxide film 9 which is located underneath it.

In the next step, as shown in Figure 1J, the Si₃N₄ film 17 is removed by etching with hot phosphoric acid or the like in a manner such that the portions which are under the silicon dioxide layer 18 are left. Thereafter, an aluminium layer is formed on the entire surface and is then patterned so as to form a pair of resistor electrodes 19t, an emitter electrode 19e, a base electrode 19b and a collector electrode 19c, thereby producing a composite device which comprises a bipolar transistor Tr of a poly-washed emitter structure and a resistor R.

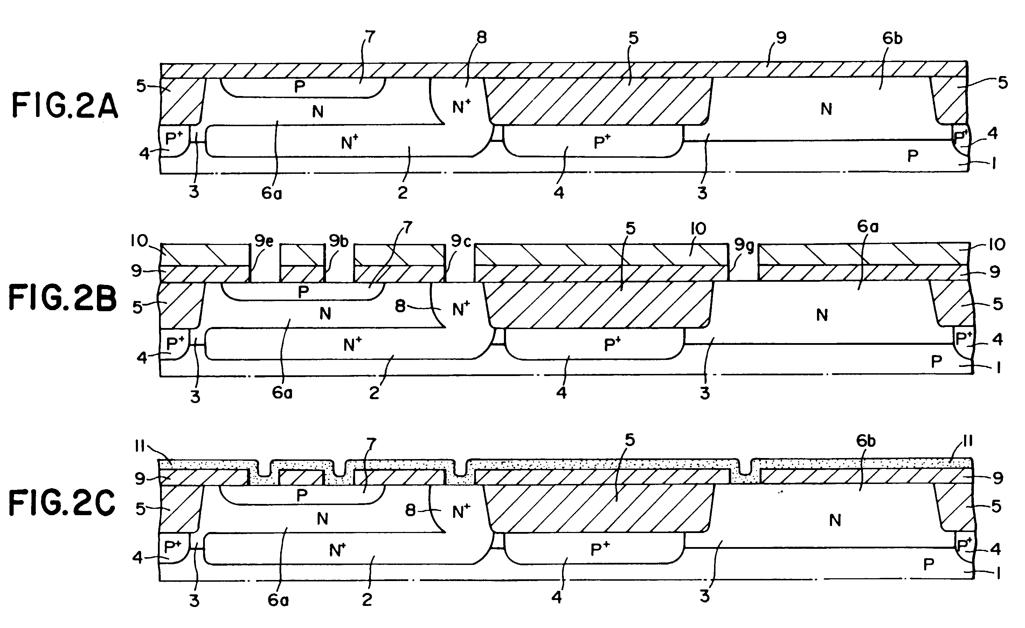

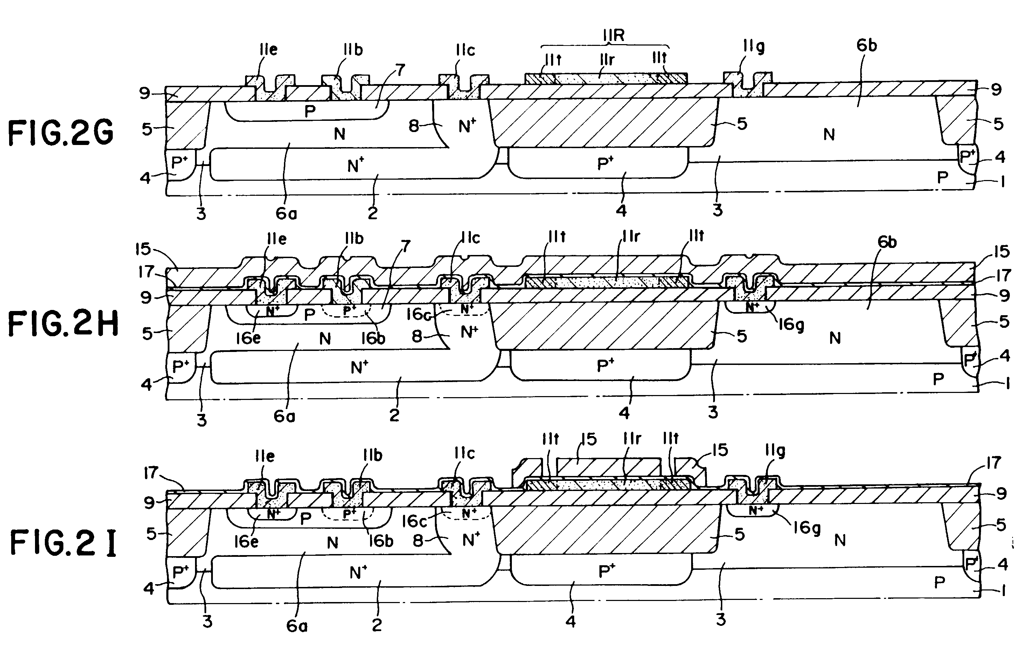

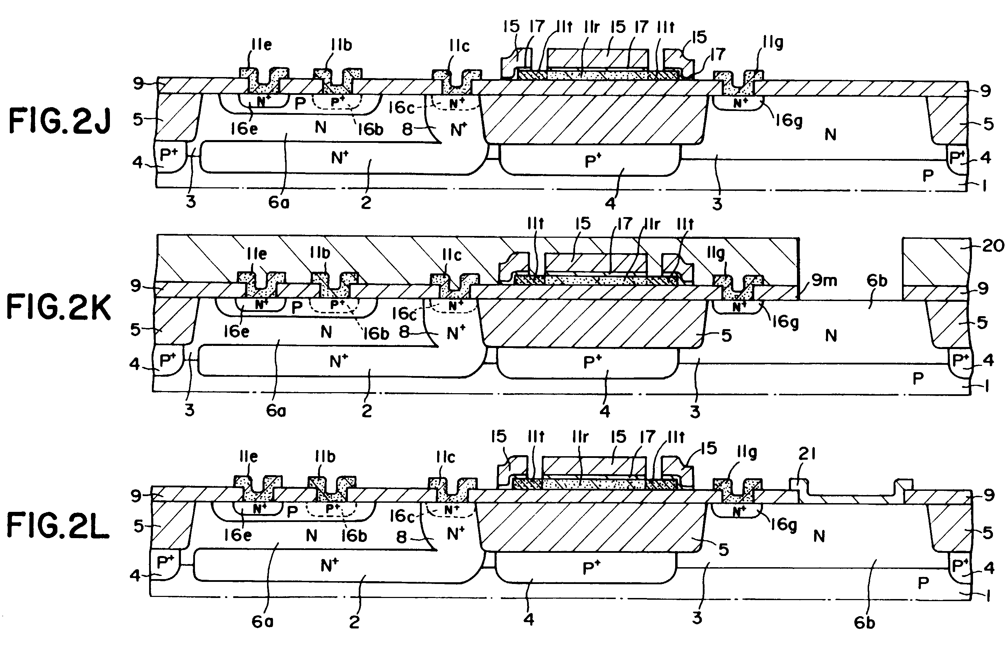

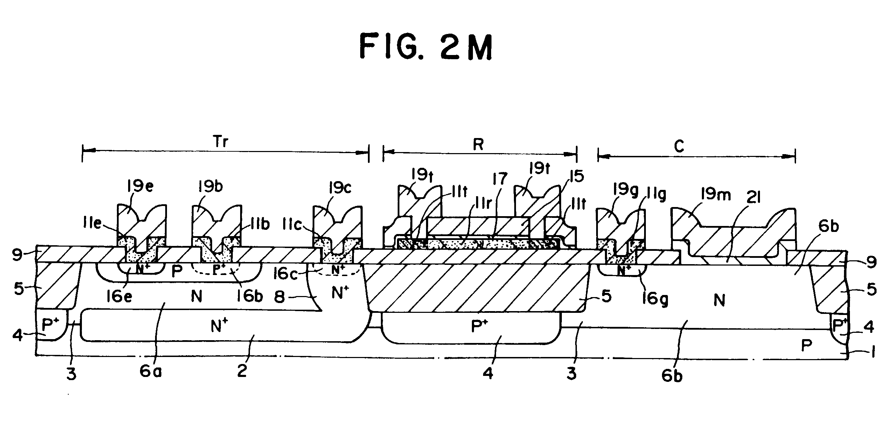

A second method embodying the invention for simultaneously producing the above-described composite device and, also, an MIS capacitor will now be described with reference to Figures 2A to 2M, which illustrate sequential steps of the method. In Figures 2A to 2M, items which are the same as items in the first embodiment shown in Figure 1A to 1J are denoted by the same references.

First, as shown in Figure 2A, an N-type buried layer 2, an N-type epitaxial layer 3, isolated inter-element regions 4 and 5, a P-type region 7 and an N-type collector lead region 8 are formed on a P-type silicon substrate 1. Thereafter, a silicon dioxide film 9 is formed by CVD or the like on the entire surface inclusive of active regions 6a and 6b.

In the next step, as shown in Figure 2B, a resist mask 10 is formed on the silicon dioxide film 9, and the film 9 is then selectively etched through the resist mask 10 to open, simultaneously, (that is, in the same process (etching) step), windows 9e, 9b, 9c, 9g which correspond, respectively, to an emitter region (which also serves as an emitter contact), a base contact and a collector contact in the active region 6a, and one electrode lead region of the MIS capacitor in the active region 6b.

Thereafter, as shown in Figure 2C, the resist mask 10 on the silicon dioxide film 9 is removed and a polycrystalline silicon layer 11 is formed by CVD or the like on the silicon dioxide film 9 including the windows 9e, 9b, 9c, 9g.

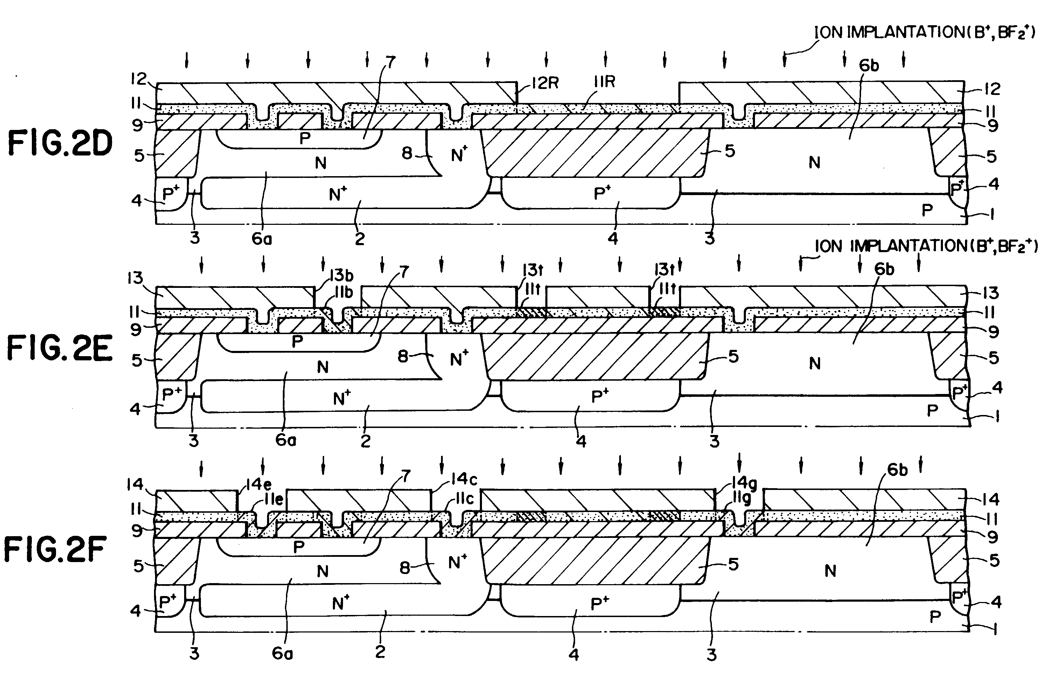

In the next step, as shown in Figure 2D, a resist mask 12 is formed on the polycrystalline silicon layer 11, and a P-type impurity, such as a boron impurity (e.g. B⁺, BF₂ ⁺), is ion-implanted through a window 12R of the resist mask 12 into a portion 11R which serves as a resistor part 11r constituted by the polycrystalline silicon layer 11.

Then, as shown in Figure 2E, the resist mask 12 on the polycrystalline silicon layer 11 is removed and another resist mask 13 is formed on the layer 11. Thereafter, a P-type impurity (e.g. B⁺, BF₂ ⁺) is ion-implanted through windows 13t, 13b of the resist mask 13 into resistor contact portions 11t of the polycrystalline silicon layer 11 and a portion 11b which corresponds to the base contact.

Next, as shown in Figure 2F, the resist mask 13 on the polycrystalline silicon layer 11 is removed and a resist mask 14 is formed on the layer 11. Thereafter, an N-type impurity (e.g. As⁺) is ion-implanted through windows 14e, 14c, 14g of the resist mask 14 into a portion 11e of the polycrystalline silicon layer 11 which corresponds to the emitter region, a portion 11c of the layer 11 which corresponds to a collector contact, and a portion 11g of the layer 11 which corresponds to the one electrode lead region of the MIS capacitor.

Subsequently, as shown in Figure 2G, the resist mask 14 on the polycrystalline silicon layer 11 is removed and then the polycrystalline silicon layer 11 is patterned. In this stage, the patterning is performed so as to leave the resistor part 11r, the resistor contact portions 11t, the portion 11e which corresponds to the emitter region, the portion 11b which corresponds to the base contact, the portion 11c which corresponds to the collector contact, and the portion 11g which corresponds to the one electrode lead region of the MIS capacitor.

Next, as shown in Figure 2H, a relatively thin Si₃N₄ film 17 is formed on the entire surface by decompressed CVD or the like, and then a relatively thick silicon dioxide film 15 is formed on the Si₃N₄ film 17 by CVD or the like. In similar member to the first embodiment, the silicon dioxide film 15 functions as a cap film. Thereafter, heat treatment is performed. In this stage, the N-type impurities from the portion 11e of the polycrystalline silicon layer 11 which corresponds to the emitter region, the portion 11c of the layer 11 which corresponds to the collector contact, and the portion 11g of the layer 11 which corresponds to the one electrode lead region of the MIS capacitor are diffused into the base region 7, the collector lead region 8 and the active region 6b, which are located under such portions, respectively, thereby forming an emitter region 16e (which also serves as an emitter contact), a collector contact 16c (shown by a broken line) and the one electrode lead region 16g of the MIS capacitor. Simultaneously, the P-type impurity from the portion 11b of the polycrystalline silicon layer 11 which corresponds to the base contact is diffused into the base region 7 so as to form a base contact 16b (shown by a broken line).

Next, as shown in Figure 2I, the silicon dioxide film 15 is patterned so that the portions thereof on the resistor part 11r and the resistor contact portions 11t are left unremoved. In this stage, the Si₃N₄ film 17 functions as an etching stopper to prevent removal of the silicon dioxide film 9 which is located underneath it.

Subsequently, as shown in Figure 2J, the Si₃N₄ film 17 is etched with hot phosphoric acid or the like in a manner such that the portions located under the silicon dioxide film 15 are left.

In the next step, as shown in Figure 2K, a resist mask 20 is formed on the entire surface, and the silicon dioxide film 9 is then selectively etched through the resist mask 20 to open a window 9m which communicates with the active region 6b and determines the capacitance (area) of the MIS capacitor.

Next, as shown in Figure 2L, a Si₃N₄ film 21 which is thicker than the Si₃N₄ film 17 is formed on the entire surface by decompressed CVD or the like, and the film 21 is then patterned so that the portion of the film 21 which corresponds to the window 9m is left. The Si₃N₄ film 21 is used as a dielectric film of the MIS capacitor.

Thereafter, as shown in Figure 2M, an aluminium layer is formed on the entire surface and is then patterned so as to form a pair of resistor electrodes 19t of the resistor part 11r, an emitter electrode 19e, a base electrode 19b, a collector electrode 19c, an electrode 19g of the MIS capacitor, and another electrode 19m of the MIS capacitor, thereby producing a composite device which comprises a bipolar transistor Tr of a poly-washed emitter structure, a resistor R and an MIS capacitor C.

According to this embodiment, as described above, windows 9e, 9b, 9c which correspond to ohmic contacts of a transistor, i.e. an emitter region 16e, a base contact 16b and a collector contact 16c, and also another window 9g which corresponds to an ohmic contact of the MIS capacitor, i.e. one electrode lead region 16g of the MIS capacitor (as shown in Figures 1B and 2B), can be formed at the same time. After a polycrystalline silicon layer 11 is formed on the entire surface including the windows 9e, 9b, 9c, 9g which correspond to such ohmic contacts, P-type and N-type impurities are selectively introduced by ion implantation into the portions 11e, 11b, 11c, 11g of the layer 11 which correspond to the ohmic contacts and the isolated other element region 11R, whereby the resistor R and the MIS capacitor C can be produced simultaneously with the bipolar transistor Tr. Furthermore, since only a single resist mask (the mask 10) is required for forming the windows 9e, 9b, 9c, 9g which correspond to the ohmic contacts, the steps of forming the ohmic contacts are simplified. Particularly in the case of simultaneously producing the MIS capacitor C therewith, the step relating to the capacitor C can be executed in the final stage as shown in Figure 2L, so that any adverse (harmful) influences resulting from heat treatment and so forth (shown in Figure 2H) are prevented (that is, the dielectric constant of the Si₃N₄ film 21 which serves as the dielectric film is not affected), thus producing a satisfactory MIS capacitor with high precision of control of the capacitance.

In addition, as described in connection with the second embodiment where the polycrystalline silicon layer 11 is patterned immediately after the step of ion implantation (shown in Figures 2D to 2F), the cap silicon dioxide film 15 formed thereafter can be patterned without being entirely removed and can therefore be utilised as an interlayer insulator film for the resistor contact portions 11t. Consequently, it becomes possible to eliminate the double operation of first forming the cap silicon dioxide film 15 as in the first embodiment and, after the heat treatment, removing the entire cap silicon dioxide film 15, then forming a silicon dioxide film 18 again and patterning it to obtain an interlayer insulator film for the resistor contact portions 11t.

Also, with regard to the step of ion implantation, an advantage is obtained in that, since the ion implantation is executed into the substrate where the element regions and the windows corresponding to the entire ohmic contacts relative to the elements have previously been formed, the ion implantation for the individual conduction types as a whole ranges from a minimum of twice (once for P-type and once for Ntype) to a maximum of four times (twice for P-type and twice for Ntype), so that the steps of ion implantation can be simplified. In this embodiment, the ion implantation is repeated only a total of three times (twice for P-type and once for N-type).

Also, the polycrystalline silicon layer 11 can be used to obtain both a polycrystalline silicon layer which is used for forming the resistor part 11r, the resistor contact portions 11t and the portion 11g corresponding to one electrode lead region 16g of the MIS capacitor, and another polycrystalline silicon layer which is used for forming the contacts to the diffused regions 16e, 16b, 16c of the bipolar transistor Tr. Therefore, all of the contact portions can be formed out of the single polycrystalline silicon layer 11 during one patterning step, hence simplifying the process for shaping the contact portions.

The first embodiment relates to the simultaneous production of an NPN-type bipolar transistor Tr and a resistor R; while the second embodiment relates to the simultaneous production of an NPN-type bipolar transistor Tr, a resistor R and an MIS capacitor C. However, a PNP-type bipolar transistor may be produced in place of the above NPN-type bipolar transistor, or a MOS transistor may be produced as well. Furthermore, it is possible to simultaneously produce a bi-MOS transistor or a bi-CMOS transistor with a resistor and a MIS capacitor.

According to the above-described semiconductor device manufacturing methods embodying the invention, windows corresponding to ohmic contacts are opened at the same time and, after a semiconductor layer is formed on the entire surface including such open windows, impurities are selectively introduced by ion implantation into the portions of the semiconductor layer which correspond to the contacts and the isolated other element region to produce a transistor and at least one other element. Consequently, simultaneous production of a transistor and other elements (at least a resistor and optionally a capacitor and/or a transistor of another type) can be realised with a simplified process of manufacture.

## Claims

1. A method of manufacturing a transistor (Tr) and a resistor (R), the method comprising the steps of:
forming N and P regions (2, 3, 4, 6, 7, 8), including a base region (7) and a collector lead region (8), in a major surface of a silicon substrate (1);
forming an insulating film (9) on said major surface of the substrate (1);
forming a first resist mask (10) on the insulating film (9);
selectively etching the insulating film (9) through the first resist mask (10) to form a plurality of windows (9e, 9b, 9c) to the substrate (1) in areas where an emitter region, a base contact and a collector contact are to be formed;
removing the first resist mask (10);
forming a polycrystalline silicon layer (11) on the insulating film (9) and in the plurality of windows (9e, 9b, 9c);
forming a second resist mask (12) on the polycrystalline layer (11);
ion-implanting a P-type impurity through a window (12R) of the second resist mask (12) into a portion (11R) of the polycrystalline silicon layer (11) which will be a resistor part (11r);
removing the second resist mask (12);
forming a third resist mask (13) on the polycrystalline layer (11);
ion-implanting a P-type impurity through windows (13t, 13b) of the third resist mask (13) to form resistor contact portions (11t) and to implant a portion (11b) of the polycrystalline silicon layer overlying an area where the base contact is to be formed;
removing the third resist mask (13);
forming a fourth resist mask (14) on the polycrystalline layer (11);
ion-implanting a N-type impurity through windows (14e, 14c) of the fourth resist mask (14) into portions (11e, 11c) of the polycrystalline silicon layer (11) overlying areas where the emitter region and the collector contact are to be formed:
removing the fourth resist mask (14);
forming another insulating film (15) on the polycrystalline layer (11);
heat treating the substrate structure and diffusing the N-type impurity from the portions (11e, 11c) of the polycrystalline silicon layer (11) overlying the areas where the emitter region and the collector contact are to be formed, and into the base region (7) and the collector lead region (8), respectively, thus forming said emitter region (16e) and said collector contact (16c), and simultaneously diffusing the P-type impurity from the portion (11b) of the polycrystalline silicon layer (11) overlying the area where the base contact is to be formed, and into the base region (7) thus forming said base contact (16b);
removing the other insulating film (15);
patterning the polycrystalline silicon layer (11) to leave the resistor part (11r), the resistor contact portions (11t), the portion (11e) which overlies the emitter region (16e), the portion (11b) overlying the base contact (16b), and the portion (11c) overlying the collector contact (16c);
forming a thin film (17) over the surface of the structure;
forming a relatively thick insulating film (18) on the thin film (17);
patterning the relatively thick insulating film (18) so that it is partially left on the resistor part (llr) and the resistor contact portions (11t) wherein the thin film (17) acts as an etch stop;
removing the thin film (17) except for those portions under the remaining portion of the relatively thick insulating layer (18); and
forming resistor electrodes (19t), an emitter electrode (19e), a base electrode (19b) and a collector electrode (19c).

2. A method of manufacturing a transistor (Tr), a resistor (R) and a capacitor (C), the method comprising the steps of:
forming N and P regions (2, 3, 4, 6a, 6b, 7, 8), including a base region (7), a collector lead region (8) and an active region (6b), in a major surface of a silicon substrate (1);
forming a first insulating film (9) on said major surface of the substrate (1);
forming a first resist mask (10) on the insulating film (9);
selectively etching the insulating film (9) through the first resist mask (10) to form a plurality of windows (9e, 9b, 9c, 9g) to the substrate (1) in areas where an emitter region, a base contact, a collector contact and a lead of the capacitor (C) are to be formed;
removing the first resist mask (10);
forming a polycrystalline silicon layer (11) on the insulating film (9) and in the plurality of windows (9e, 9b, 9c, 9b);
forming a second resist mask (12) on the polycrystalline layer (11);
ion-implanting a P-type impurity through a window (12R) of the second resist mask (12) into a portion (11R) of the polycrystalline layer (11) which will be a resistor part (11r);
removing the second resist mask (12);
forming a third resist mask (13) on the polycrystalline layer (11);
ion-implanting a P-type impurity through windows (13t, 13b) of the third resist mask (13) to form resistor contact portions (11t) and to implant a portion (11b) of the polycrystalline silicon layer (11) overlying an area where the base contact is to be formed;
removing the third resist mask (13);
forming a fourth resist mask (14) on the polycrystalline layer (11);
ion-implanting an N-type impurity through windows (14e, 14c, 14g) of the fourth resist mask (14) into portions (11e, 11e, 11g) of the polycrystalline silicon layer (11) overlying areas where the emitter region, the collector contact and the lead of the capacitor (C) are to be formed;
removing the fourth resist mask (14);
patterning the polycrystalline silicon layer (11) to leave the resistor part (11r), the resistor contact portions (11t), and the portions (11e, 11b, 11e, 11g) overlying the areas where the emitter region, the base contact portion, the collector contact and the lead of the capacitor are to be formed;
forming a thin film (17) on the surface of the structure;
forming a second insulating film (15) on the thin film (17);
heat treating the substrate structure and diffusing the N-type impurity from the portions (11e, 11c, 11g) of the polycrystalline layer (11) overlying the areas where the emitter region, the collector contact and the capacitor lead are to be formed, and into the base region (7), the collector lead region (8) and the active region (6b), respectively, thus forming the emitter region (16e), collector contact (16c) and one lead of the capacitor (C), and simultaneously diffusing the P-type impurity from the portion (11b) of the polycrystalline silicon layer overlying the area where the base contact portion is to be formed and into the base region (7) thus forming said base contact (16b);
patterning the second insulating film (15) to leave portions over the resistor part (11r) and the resistor contact portions (11t) of the polycrystalline silicon layer wherein the thin film (17) acts as an etch stop;
removing the thin film (17) except for those portions under the remaining portions of the second insulating film (15);
forming a fifth resist mask (20) on the substrate structure;
selectively etching the first insulating film (9) to open a further window (9m) which communicates with the active region (6b) and determines the capacitance of the capacitor (C);
forming a further film (21) on the substrate structure;
patterning the further film (21) so that only a portion of the film (21) which corresponds to the further window (9m) is left; and
forming electrodes (19t) for the resistor part (11r), an emitter electrode (19e), a base electrode (19g), a collector electrode (19c) and two capacitor electrodes (19g, 19m).

## Patentansprüche

1. Verfahren zur Herstellung eines Transistors (Tr) und eines Widerstands (R) mit den Verfahrenschritten:
Ausbilden von N- und P-Regionen (2, 3, 4, 6, 7, 8), einschließlich einer Basis-Region (7) und einer Kollektorleiter-Region (8), in einer Hauptfläche eines Siliziumsubstrats (1);
Ausbilden einer isolierenden Schicht (9) auf der genannten Hauptfläche des Substrats (1);
Ausbilden einer ersten Resistmaske (10) auf der isolierenden Schicht (9);
selektives Ätzen der isolierenden Schicht (9) durch die erste Resistmaske (10), um in Bereichen, in denen eine Emitter-Region, ein Basiskontakt und ein Kollektorkontakt ausgebildet werden sollen, eine Mehrzahl von Fenstern (9e, 9b, 9c) zu dem Substrat (1) zu bilden;
Entfernen der ersten Resistmaske (10);
Ausbilden einer polykristallinen Siliziumschicht (11) auf der isolierenden Schicht (9) und in der Mehrzahl von Fenstern (9e, 9b, 9c);
Ausbilden einer zweiten Resistmaske (12) auf der polykristallinen Schicht (11);
lonenimplantieren einer P-Verunreinigung durch ein Fenster (12R) der zweiten Resistmaske (12) in einen Abschnitt (11R) der polykristallinen Siliziumschicht (11) hinein, der ein Widerstandsteil (11r) werden soll;
Entfernen der zweiten Resistmaske (12);
Ausbilden einer dritten Resistmaske (13) auf der polykristallinen Schicht (11);
lonenimplantieren einer P-Verunreinigung durch Fenster (13t, 13b) der dritten Resistmaske (13), um Widerstandskontaktabschnitte (11t) auszubilden und einen Abschnitt (11b) der polykristallinen Siliziumschicht zu implantieren, der über dem Bereich liegt, in dem der Basiskontakt ausgebildet werden soll;
Entfernen der dritten Resistmaske (13);
Ausbilden einer vierten Resistmaske (14) auf der polykristallinen Schicht (11);
lonenimplantieren einer N-Verunreinigung durch Fenster (14e, 14c) der vierten Resistmaske (14) in Abschnitte (11e, 11c) der polykristallinen Siliziumschicht (11) hinein, die über Bereichen liegen, in denen die Emitter-Region und der Kollektorkontakt ausgebildet werden sollen;
Entfernen der vierten Resistmaske (14);
Ausbilden einer weiteren isolierenden Schicht (15) auf der polykristallinen Schicht (11);
Wärmebehandlung der Substratstruktur und Diffundieren der N-Verunreinigung aus den Abschnitten (11e, 11c) der polykristallinen Siliziumschicht (11), die über den Bereichen liegen, in denen die Emitter-Region und der Kollektorkontakt ausgebildet werden sollen, und in die Basis-Region (7) bzw. in die Kollektorleiter-Region (8) hinein, um so die Emitter-Region (16e) und den Kollektorkontakt (16c) auszubilden, und gleichzeitiges Diffundieren der P-Verunreinigung aus dem Abschnitt (11b) der polykristallinen Siliziumschicht (11), der über dem Bereich liegt, in dem der Basiskontakt ausgebildet werden soll, und in die Basis-Region (7) hinein, und auf diese Weise Ausbilden des Basiskontakts (16b);
Entfernen der weiteren isolierenden Schicht (15);
Mustern der polykristallinen Siliziumschicht (11) in der Weise, daß der Widerstandsteil 11r), die Widerstandskontaktabschnitte (11t), der Abschnitt (11e), der über der Emitter-Region (16e) liegt, der Abschnitt (11b), der über dem Basiskontakt (16b) liegt, und der Abschnitt (11c), der über dem Kollektorkontakt (16c) liegt, verbleiben;
Ausbilden einer dünnen Schicht (17) über der Oberfläche der Struktur;
Ausbilden einer relativ dicken isolierenden Schicht (18) auf der dünnen Schicht (17);
Mustern der relativ dicken isolierenden Schicht (18) in der Weise, daß sie auf dem Widerstandsteil (11r) und den Widerstandskontaktabschnitten (11t) teilweise verbleibt, wobei die dünne Schicht (17) als Ätzstop wirkt;
Entfernen der dünnen Schicht (17) mit Ausnahme der Abschnitte unter dem verbleibenden Abschnitt der relativ dicken isolierenden Schicht (18); und
Ausbilden von Widerstandselektroden (19t), einer Emitter-Elektrode (19e), einer Basis-Elektrode (19b) und einer Kollektor-Elektrode (19c).

2. Verfahren zur Herstellung eines Transistors (Tr), eines Widerstands (R) und eines Kondensators (C) mit den Verfahrenschritten:
Ausbilden von N- und P-Regionen (2, 3, 4, 6a, 6b, 7, 8), einschließlich einer Basis-Region (7), einer Kollektorleiter-Region (8) und einer aktiven Region in einer Hauptfläche eines Siliziumsubstrats (1);
Ausbilden einer isolierenden Schicht (9) auf der genannten Hauptfläche des Substrats (1);
Ausbilden einer ersten Resistmaske (10) auf der isolierenden Schicht (9);
Selektives Ätzen der isolierenden Schicht (9) durch die erste Resistmaske (10), um in Bereichen, in denen eine Emitter-Region, ein Basiskontakt, ein Kollektorkontakt und ein Leiter des Kondensators (C) ausgebildet werden sollen, eine Mehrzahl von Fenstern (9e, 9b, 9c, 9g) zu dem Substrat (1) zu bilden;
Entfernen der ersten Resistmaske (10);
Ausbilden einer polykristallinen Siliziumschicht (11) auf der isolierenden Schicht (9) und in der Mehrzahl von Fenstern (9e, 9b, 9c, 9g);
Ausbilden einer zweiten Resistmaske (12) auf der polykristallinen Schicht (11);
lonenimplantieren einer P-Verunreinigung durch ein Fenster (12R) der zweiten Resistmaske (12) in einen Abschnitt (11R) der polykristallinen Siliziumschicht (11) hinein, der ein Widerstandsteil (11r) werden soll;
Entfernen der zweiten Resistmaske (12);
Ausbilden einer dritten Resistmaske (13) auf der polykristallinen Schicht (11);
lonenimplantieren einer P-Verunreinigung durch Fenster (13t, 13b) der dritten Resistmaske (13), um Widerstandskontaktabschnitte (11t) auszubilden und einen Abschnitt 11b) der polykristallinen Siliziumschicht (11) zu implantieren, der über dem Bereich liegt, in dem der Basiskontakt ausgebildet werden soll;
Entfernen der dritten Resistmaske (13);
Ausbilden einer vierten Resistmaske (14) auf der polykristallinen Schicht (11);
lonenimplantieren einer N-Verunreinigung durch Fenster (14e, 14c, 14g) der vierten Resistmaske (14) in Abschnitte (11e, 11c, 11g) der polykristallinen Siliziumschicht (11) hinein, die über Bereichen liegen, in denen die Emitter-Region, der Kollektorkontakt und der Leiter des Kondensators (C) ausgebildet werden sollen;
Entfernen der vierten Resistmaske (14);
Mustern der polykristallinen Siliziumschicht (11) in der Weise, daß der Widerstandsteil (11r), die Widerstandskontaktabschnitte (11t) und die Abschnitte (11e, 11b, 11e, 11g) verbleiben, die über den Bereichen liegen, in denen der Emitter-Region (16e), der Basiskontakt (16b), der Kollektorkontakt (16c) und der Leiter des Kondensators (C), ausgebildet werden sollen;
Ausbilden einer dünnen Schicht (17) über der Oberfläche der Struktur;
Ausbilden einer zweiten isolierenden Schicht (15) auf der dünnen Schicht (17);
Wärmebehandlung der Substratstruktur und Diffundieren der N-Verunreinigung aus den Abschnitten (11e, 11c, 11g) der polykristallinen Siliziumschicht (11), die über den Bereichen liegen, in denen die Emitter-Region, der Kollektorkontakt und der Leiter des Kondensators ausgebildet werden sollen, und in die Basis-Region (7), in die Kollektorleiter-Region (8) bzw. die aktive Region (6c) hinein, und auf diese Weise Ausbilden der Emitter-Region (16e), des Kollektorkontakts (16c) und eines Leiters des Kondensators (C), und gleichzeitiges Diffundieren der P-Verunreinigung aus dem Abschnitt (11b) der polykristallinen Siliziumschicht, der über dem Bereich liegt, in dem der Basiskontakt ausgebildet werden soll, und in die Basis-Region (7) hinein, um so den Basiskontakt (16b) auszubilden;
Mustern der zweiten isolierenden Schicht (15) in der Weise, daß Abschnitte über dem Widerstandsteil (11r) und den Widerstandskontaktabschnitten (11t) der polykristallinen Siliziumschicht verbleiben, wobei die dünne Schicht (17) als Ätzstop wirkt;
Entfernen der dünnen Schicht (17) mit Ausnahme der Abschnitte unter dem verbleibenden Abschnitt der zweiten isolierenden Schicht (15);
Ausbilden einer fünften Resistmaske (20) auf der Substratstruktur;
selektives Ätzen der ersten isolierenden Schicht (9) zum Öffnen eines weiteren Fensters (9m), das mit der aktiven Region (6b) in Verbindung steht und die Kapazität des Kondensators (C) bestimmt;
Ausbilden einer weiteren Schicht (21) auf der Substratstruktur;
Mustern der weiteren Schicht (21) in der Weise, daß ein dem weiteren Fenster (9m) entsprechender Teil der Schicht (21) verbleibt; und
Ausbilden von Elektroden (19t) für den Widerstandsteil (11r), einer Emitter-Elektrode (19e), einer Basis-Elektrode (19b), einer Kollektor-Elektrode (19c) und zweier Kondensator-Elektroden (19g, 19m).

## Revendications

1. Procédé de fabrication d'un transistor (Tr) et d'une résistance (R), comprenant les étapes suivantes :
- la formation de zones N et P (2, 3, 4, 6, 7, 8) comprenant une zone de base (7) et une zone de conducteur de collecteur (8) sur une surface principale d'un support de silicium (1);
- la formation d'un film isolant (9) sur ladite surface principale du support (1);
- la formation d'un premier masque de réserve (10) sur le film isolant (9);
- l'attaque chimique sélective du film isolant (9) via le premier masque de réserve (10) pour former une pluralité de fenêtres (9e, 9b, 9c) vers le support (1) dans des zones où doivent être formés une zone d'émetteur, un contact de base et un contact de collecteur;
- l'enlèvement du premier masque de réserve (10);
- la formation d'une couche de silicium polycristallin (11) sur le film isolant (9) et dans la pluralité de fenêtres (9e, 9b, 9c);
- la formation d'un second masque de réserve (12) sur la couche de silicium polycristallin (11);
- l'implantation ionique d'une impureté du type P via une fenêtre (12R) du second masque de réserve (12) dans une partie (11R) de la couche de silicium polycristallin (11) qui sera une partie de résistance (11r);
- l'enlèvement du second masque de réserve (12);
- la formation d'un troisième masque de réserve (13) sur la couche de silicium polycristallin (11);
- l'implantation ionique d'une impureté de type P via les fenêtres (13t, 13b) du troisième masque de réserve (13) pour former des parties de contact de résistance (11t) et pour implanter une partie (11b) de la couche de silicium polycristallin (11) recouvrant une zone où le contact de base doit être formé;
- l'enlèvement du troisième masque de réserve (13);
- la formation d'un quatrième masque de réserve (14) sur la couche de silicium polycristallin (11);
- l'implantation ionique d'une impureté de type N via les fenêtres (14e, 14c) du quatrième masque de réserve (14) dans des parties (11e, 11c) de la couche de silicium polycristallin (11) recouvrant des zones où la zone d'émetteur et le contact de collecteur doivent être formés;
- l'enlèvement du quatrième masque de réserve (14);
- la formation d'un autre film isolant (15) sur la couche de silicium polycristallin (11);
- le traitement à chaud de la structure du support et la diffusion de l'impureté de type N à partir des parties (11e, 11c) de la couche de silicium polycristallin (11) recouvrant les zones où la zone d'émetteur et le contact de collecteur doivent être formés, et respectivement dans la zone de base (7) et la zone de conducteur de collecteur (8), formant alors ladite zone d'émetteur (16e) et ledit contact de collecteur (16c), et la diffusion, de façon simultanée, de l'impureté de type P à partir de la partie (11b) de la couche de silicium polycristallin (11) recouvrant la zone où le contact de base doit être formé, et dans la zone de base (7), formant alors ledit contact de base (16b);
- l'enlèvement de l'autre film isolant (15);
- la formation de motifs sur la couche de silicium polycristallin (11) pour découvrir la partie de résistance (11r), les parties de contact de résistance (11d), la partie (11e) recouvrant la zone d'émetteur (16e), la partie (11b) recouvrant le contact de base (16b) et la partie (11c) recouvrant le contact de collecteur (16c);
- la formation d'un film mince (17) sur la surface de la structure;
- la formation d'un film isolant relativement épais (18) sur le film mince (17);
- la formation de motifs sur le film isolant relativement épais (18) de telle façon qu'il soit partiellement découvert sur la partie de résistance (11r) et les parties de contact de résistance (11t) où le film mince (17) sert d'arrêt d'attaque chimique;
- l'enlèvement du film mince (17) à l'exception des parties sous la partie restante de la couche isolante relativement épaisse (18); et
- la formation d'électrodes de résistance (19t), d'une électrode d'émetteur (19e), d'une électrode de base (19b) et d'une électrode de collecteur (19c).

2. Procédé de fabrication d'un transistor Tr, d'une résistance R et d'un condensateur (C) comprenant les étapes suivantes :
- la formation de zones N et P (2, 3, 4, 6a, 6b, 7, 8) comprenant une zone de base (7), une zone de conducteur de collecteur (8) et une zone active (6b) sur une surface principale d'un support de silicium (1);
- la formation d'un premier film isolant (9) sur ladite surface principale du support (1);
- la formation d'un premier masque de réserve (10) sur le film isolant (9);
- l'attaque chimique sélective du film isolant (9) via le premier masque de réserve (10) pour former une pluralité de fenêtres (9e, 9b, 9c, 9g) vers le support (1) dans des zones où doivent être formés une zone d'émetteur, un contact de base, un contact de collecteur et un conducteur de condensateur (C);
- l'enlèvement du premier masque de réserve (10) ;
- la formation d'une couche de silicium polycristallin (11) sur le film isolant (9) et dans la pluralité de fenêtres (9e, 9b, 9c, 9g) ;
- la formation d'un second masque de réserve (12) sur la couche de silicium polycristallin (11);
- l'implantation ionique d'une impureté du type P via une fenêtre (12R) du second masque de réserve (12) dans une partie (11R) de la couche de silicium polycristallin (11) qui sera une partie de résistance (11r);
- l'enlèvement du second masque de réserve (12);
- la formation d'un troisième masque de réserve (13) sur la couche de silicium polycristallin (11);
- l'implantation ionique d'une impureté de type P via les fenêtres (13t, 13b) du troisième masque de réserve (13) pour former des parties de contact de résistance (11t) et pour implanter une partie (11b) de la couche de silicium polycristallin (11) recouvrant une zone où le contact de base doit être formé;
- l'enlèvement du troisième masque de réserve (13);
- la formation d'un quatrième masque de réserve (14) sur la couche de silicium polycristallin (11);
- l'implantation ionique d'une impureté de type N via les fenêtres (14e, 14c, 14g) du quatrième masque de réserve (14) dans des parties (11e, 11c, 11g) de la couche de silicium polycristallin (11) recouvrant des zones où la zone d'émetteur, le contact de collecteur et le conducteur du condensateur (C) doivent être formés;
- l'enlèvement du quatrième masque de réserve (14);
- la formation de motif sur la couche de silicium polycristallin (11) pour découvrir la partie de résistance (11r), les parties de contact de résistance (11t) et les parties (11e, 11b, 11c, 11g) recouvrant les zones où la zone d'émetteur, la partie de contact de base, le contact de collecteur et le conducteur du condensateur doivent être formés;
- la formation d'un film mince (17) sur la surface de la structure;
- la formation d'un autre film isolant (15) sur le film mince (17);
- le traitement à chaud de la structure du support et la diffusion de l'impureté de type N à partir des parties (11e, 11c, 11g) de la couche de silicium polycristallin (11) recouvrant les zones où la zone d'émetteur, le contact de collecteur et le conducteur de condensateur doivent être formés, et respectivement dans la zone de base (7), la zone de conducteur de collecteur (8) et la zone active (6b), formant alors ladite zone d'émetteur (16e), ledit contact de collecteur (16c) et un conducteur du condensateur (C), et la diffusion, de façon simultanée, de l'impureté de type P à partir de la partie (11b) de la couche de silicium polycristallin (11) recouvrant la zone où le contact de base doit être formé, et dans la zone de base (7), formant alors ledit contact de base (16b) ;
- la formation de motif sur le second film isolant (15) pour découvrir des parties sur la partie de résistance (11r) et les parties de contact de résistance (11t) de la couche de silicium polycristallin où le film mince (17) sert d'arrêt d'attaque chimique;
- l'enlèvement du film mince (17) à l'exception des parties sous les parties restantes du second film isolant (15);
- la formation d'un cinquième masque de réserve (20) sur la structure du support;
- l'attaque chimique sélective du premier film isolant (9) pour ouvrir une fenêtre supplémentaire (9m) communiquant avec la zone active (6b) et déterminant la capacitance du condensateur (C);
- la formation d'un film supplémentaire (21) sur la structure du support;
- la formation de motifs sur le film supplémentaire (21) de telle façon que seule une partie du film (21) correspondant à la fenêtre supplémentaire (9m) soit découverte; et
- la formation d'électrodes (19t) pour la partie de résistance (11r), une électrode d'émetteur (19e), une électrode de base (19g), une électrode de collecteur (19c) et deux électrodes de condensateur (19g, 19m).
